(19) **Europäisches Patentamt**

**European Patent Office**

**Office européen des brevets**

(11) Veröffentlichungsnummer: **0 236 713**

**A2**

(12) # EUROPÄISCHE PATENTANMELDUNG

(21) Anmeldenummer: **87101066.6**

(22) Anmeldetag: **27.01.87**

(51) Int. Cl.⁴: **H01S 3/02 , H01S 3/19**

(30) Priorität: **10.02.86 DE 3604192**

(43) Veröffentlichungstag der Anmeldung:
**16.09.87 Patentblatt 87/38**

(84) Benannte Vertragsstaaten:
**DE FR GB IT**

(71) Anmelder: **Siemens Aktiengesellschaft Berlin und München**
**Wittelsbacherplatz 2**
**D-8000 München 2(DE)**

(72) Erfinder: **Müller, Gustav, Dipl.-Ing.**
**Feldmochingerstrasse 41d**
**D-8000 München 50(DE)**
Erfinder: **Hartl, Engelbert, Dipl.-Ing.**
**Sammtstrasse 3a**
**D-8000 München 80(DE)**
Erfinder: **Honsberg, Martin, Dipl.-Ing.**
**Erhardtstrasse 15**
**D-8000 München 5(DE)**

(54) **Laserdiode.**

(57) Laserdiode (Fig.) mit einem Steg (8) nach dem Prinzip einer MCRW-Laserdiode mit einer Stegbreite kleiner 10 μm. Seitlich des Steges (8) erstreckt sich wenigstens ein Lateralsteg (20), der als Träger für eine elektrische Verbindung (24) vorgesehen ist, die den Streifenkontakt (7) des Steges (8) der Laserdiode mit der Kontaktierungsfläche (-schicht) (23) elektrisch verbindet, wobei diese Kontaktierungsfläche (23) für den Anschluß einer Zuleitung - (26) dient.

EP 0 236 713 A2

## Laserdiode

Die vorliegende Erfindung bezieht sich auf eine Laserdiode mit den Merkmalen des Oberbegriffes des Patentanspruches 1.

Aus der US-PS 4.352.187 und aus "Frequenz" Bd. 34 (1980) Seiten 343 bis 346 ist eine MCRW-Laserdiode mit Doppelheteroschichtstruktur und streifenförmigem Steg mit Kontaktbelegung bekannt. Bei dieser Laserdiode ist zum Zwecke verbesserter Wellenführung vorgesehen, daß die dritte Schicht der Doppelheteroschichtstruktur im Bereich seitlich des nur 2 bis 10 $\mu$m breiten Steges verringerte Dicke besitzt. Die Kontaktbelegung dieser Laserdiode reicht von der Oberseite des Steges über die Flanken des Steges herab bis auf die Oberfläche dieser in ihrer Dicke verringerten dritten Schicht der Doppelheteroschichtstruktur. Um optimale Verbesserung der Wellenführung für die Laserstrahlung zu erhalten, die in der laseraktiven, zweiten Schicht der Doppelheteroschichtstruktur erzeugt wird, ist es erforderlich, eine Restdicke der dritten Schicht der Doppelheteroschichtstruktur einzuhalten.

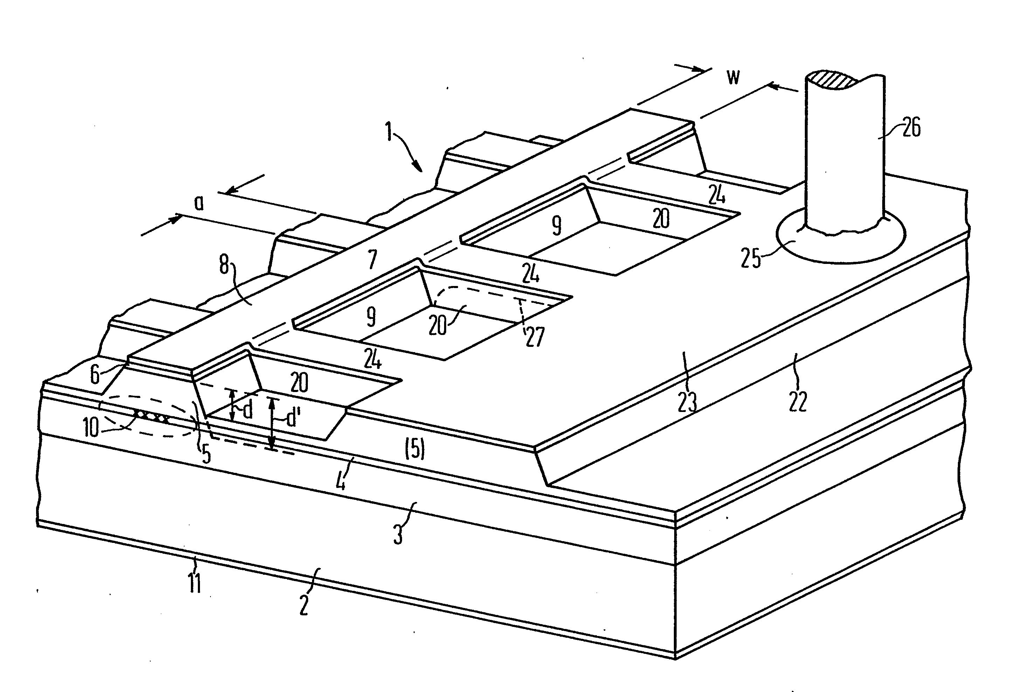

In Figur 1 in "Frequenz..." ist ein Mesa-Aufbau angegeben, bei dem die Schichtstruktur eine Breite von 150 $\mu$m hat. Ein solcher Aufbau ist nicht mit einem Steg im Sinne einer MCRW-Laserdiode - (oder einer erfindungsgemäßen Laserdiode) zu verwechseln. Bei einer solchen Breite des Aufbaus kommt keinerlei Wellenführung im Sinne und nach dem Prinzip der MCRW-Laserdiode in Betracht.

Bezüglich einer Doppelheteroschichtstruktur wird für die vorliegende Beschreibung davon ausgegangen, daß sich auf einem Substrat vier Schichten dieser Doppelheteroschichtstruktur übereinanderliegend befinden. Ohne daß dies eine wesentliche Abweichung vom Prinzip einer derartigen Doppelheteroschichtstruktur ist, können z.B. die erste Schicht und das Substrat ein und dasselbe Material sein, d.h. zusammenfallen. Auch die vierte Schicht ist nicht in jedem Falle zwingend erforderlich. Sofern es möglich ist, nämlich aufgrund der Materialauswahl für dritte Schicht, eine geeignete Kontaktbelegung an der dritten Schicht anzubringen, kann die vierte Schicht entbehrlich sein. Für die weiteren Darlegungen wird von der Vierschicht-Struktur ausgegangen, wobei die Weglassung der ersten und/oder der vierten Schicht jeweils sinngemäß mit eingeschlossen sein soll.

Aufgabe der vorliegenden Erfindung ist es, Maßnahmen anzugeben, mit denen eine Laserdiode mit Doppelheteroschichtstruktur und streifenförmigem Steg mit Kontaktbelegung mit verbesserter bzw. optimaler Wellenführung zu realisieren ist.

Diese Aufgabe wird durch eine Laserdiode mit den Merkmalen des Patentanspruches 1 gelöst und weitere Ausgestaltungen und Weiterbildungen der Erfindung gehen aus den Unteransprüchen hervor.

Der vorliegenden Erfindung liegen mehrere Gedanken zugrunde, deren Abstimmung aufeinander erst zur vorliegenden Erfindung führen konnte. Zum einen ist davon ausgegangen worden, daß eine Verringerung der Dicke der dritten Schicht in den seitlich dem Steg benachbarten Flächenanteilen prinzipiell vorteilhaft ist. Einer weiteren Verringerung der Dicke als dies nach dem oben geschilderten Stand der Technik angegeben ist, standen jedoch die begründeten Befürchtungen entgegen, daß zu geringe Restschichtdicke dieser dritten Schicht zu Kurzschlüssen zwischen der Kontaktbelegung und der zweiten, laseraktiven Schicht führen könnte. Eine entsprechend großflächige Kontaktbelegung ist jedoch zum Zwecke einwandfreier Kontaktierung des auf der Oberseite des schmalen Steges notwendigen Elektrodenstreifens nützlich. Es ist zu beachten, daß der auf der Oberseite des Steges befindliche Elektrodenstreifen für den Laserbetrieb mit relativ starkem elektrischem Strom zu speisen ist, wodurch erhebliche Anforderungen an eine Kontaktierung gestellt sind.

Die erfindungsgemäße Lösung sieht vor, daß einerseits die Kontaktbelegung auf im wesentlichen die Oberseite des Steges beschränkt wird und daß die dritte Schicht, d.h. diejenige Schicht, die in der Schichtstrukturfolge der zweiten, laseraktiven Schicht benachbart ist und die sich zwischen dieser zweiten Schicht und der die Kontaktbelegung tragenden vierten Schicht befindet, seitlich des Steges nahezu bis vollständig entfernt ist. Das heißt, daß diese dritte Schicht zumindest im Nachbarbereich des Steges nur noch eine sehr geringe Restdicke hat oder ganz beseitigt ist. Im Rahmen der vorliegenden Erfindung kann sogar noch ein Dickenanteil der zweiten Schicht entfernt sein.

Im Rahmen der vorliegenden Erfindung wird das dabei entstandene Problem der Kontaktierung der Kontaktbelegung, die nunmehr auf lediglich die Oberseite des Steges beschränkt ist (so daß diese Kontaktbelegung ein nur noch einige $\mu$m breiter Streifen ist), durch folgende weitere Maßnahmen gelöst: Quer zu dem streifenförmigen Steg ist mindestens ein, vorzugsweise sind mehrere Lateralstege vorgesehen. Dieser bzw. diese sich seitlich von dem streifenförmigen Steg der Laserdiode weg sich erstreckenden Lateralstege dienen als Träger für elektrische Kontaktverbindungen nach Art einer jeweiligen Leiterbahn.

Auch für die Lateralstege gilt, daß praktisch nur die Oberseite des jeweiligen Lateralsteges mit einer derartigen elektrischen Kontaktverbindung bedeckt ist.

Vorzugsweise ist die Höhe der Lateralstege weitgehend angenähert gleich der des eigentlichen streifenförmigen Steges der Laserdiode. Damit liegen die elektrischen Kontaktverbindungen und die streifenförmige Kontaktbelegung des Laserdioden-Steges nicht auf wesentlich verschiedener Höhe, so daß keine erheblichen Stufen vorliegen, die zu Kontaktunterbrechungen führen könnten.

Eine zweckmäßige Ausführungsform für einen oder mehrere derartige Stege ist diejenige, am jeweiligen Ort eines derartigen Lateralsteges Material der dritten Schicht der Doppelheteroschichtstruktur stehen zu lassen. Die elektrische Kontaktverbindung auf der Oberseite des Materials dieser dritten Schicht ist dann elektrisch isoliert gegenüber der zweiten, laseraktiven Schicht der Schichtstruktur. Solche Lateralstege können aber auch durch nachträglich aufgebrachtes, isolierendes Oxydmaterial realisiert sein.

Zur einfachen Kontaktierung der Laserdiode ist im Rahmen der Erfindung als weiteres Merkmal eine Kontaktierungsfläche vorgesehen, die ebenfalls gegenüber der zweiten, laseraktiven Schicht elektrisch isoliert ist. Zweckmäßigerweise ist diese Kontaktierungsfläche auf einem dafür vorgesehenen Mesa angeordnet. Zweckmäßigerweise besteht dieser Mesa aus einem nicht beseitigten Anteil der dritten Schicht. In diesem Falle bestehen dann die Lateralstege und der Mesa dieser Kontaktierungsfläche und ein Anteil des streifenförmigen Steges der eigentlichen Laserdiode aus nicht beseitigten Teilen der dritten Schicht, wobei im Regelfall der streifenförmige Steg der Laserdiode die vierte Schicht unterhalb der streifenförmigen Kontaktbelegung einschließt. Der Vollständigkeit halber sei darauf hingewiesen, daß das Material der vierten Schicht praktisch nur dazu dient, niederohmigen ohmschen Kontakt zwischen der Kontaktbelegung des streifenförmigen Steges und dem unterhalb dieser vierten Schicht befindlichen Material der dritten Schicht zu erreichen. Im Bereich der Lateralstege und der Kontaktierungsfläche liegt dagegen im Regelfall ein sperrender Übergang vor, wie dies von der bekannten MCRW-Laserdiode hinlänglich bekannt ist.

Weitere Erläuterungen der Erfindung gehen aus der nachfolgenden Beschreibung eines Ausführungsbeispiels hervor.

Mit 1 ist eine erfindungsgemäße Laserdiode bezeichnet. Auf dem mit 2 bezeichneten Substratkörper aus z.B. n-Indiumphosphid befinden sich die vier Schichten der Doppelheterostruktur. Die erste Schicht ist mit 3 bezeichnet und besteht z.B. aus Indiumphosphid. Die nächstfolgende mit 4 bezeichnete Schicht ist die zweite, laseraktive Schicht der Schichtstruktur. Sie ist vorzugsweise i-leitend und besteht z.B. aus Indium-Galliumarsenid-Phosphid. Die dritte Schicht der Doppelheterostruktur ist mit 5 bezeichnet. Sie besteht aus p-leitendem Material, z.B. Indiumphosphid.

Die oberste vierte Schicht der Schichtstruktur ist mit 6 bezeichnet und sie besteht aus relativ hochdotiertem, vorzugsweise p-leitendem Material, wie z.B. Indiumphosphid.

Der Streifenkontakt, z.B. aus Gold, ist mit 7 bezeichnet.

Wie aus der Figur ersichtlich, ist auch hier der für eine MCRW-Laserdiode typische langgestreckte Steg vorhanden, der mit 8 bezeichnet ist. Diesem Steg 8 kommt auch bei der Erfindung die von der MCRW-Laserdiode her bekannte Funktion zu. Die Flanken 9 des Steges 8 sind bei der Erfindung jedoch vorzugsweise frei von einer Metallbelegung, wie dies für eine MCRW-Laserdiode typisch ist.

Wie aus der Figur ersichtlich, ist auf beiden Seiten des Steges 8 das Material der dritten Schicht 5 der Doppelheteroschichtstruktur entfernt, vorzugsweise nach fotolithografischem Verfahren herausgeätzt. Es bedarf keines besonderen Hinweises, daß die entsprechenden Anteile der Schicht 6 ebenfalls entfernt sind.

Bei der Erfindung ist die Tiefe d, bis zu der das Material der Schicht 5 entfernt ist, vorzugsweise größer als bei einer MCRW-Laserdiode, insbesondere ist die Tiefe d nahezu oder sogar gleich der gesamten Schichtdicke der Schicht 5. Die Vertiefungen seitlich des Steges 8 reichen dann bis auf die laseraktive Schicht 4 herab. Bei der Erfindung kann sogar vorgesehen sein, daß noch bis in die Schicht 4 bzw. durch die Schicht 4 hindurch - (d′) das Halbleitermaterial der Schichtstruktur entfernt ist, wie dies gestrichelt angedeutet ist. Diese bei der Erfindung vorgesehene Ausbildung des Steges 8 trägt wesentlich dazu bei, daß gute Wellenführung für die erzeugte Laserstrahlung vorliegt, deren Austrittsstelle mit 10 angedeutet ist.

Mit 20 sind bei der Erfindung vorgesehene Lateralstege bezeichnet. Es kann ein einzelner Lateralsteg 20 vorgesehen sein. Vorteilhafter ist jedoch eine Anordnung von mehreren Lateralstegen 20, die vorzugsweise außerdem in periodischen Abständen angeordnet sind. Eine solche Periodizität der Anordnung derartiger Lateralstege wirkt sich günstig auf Monomodenselektion aus. Mit 22 ist ein Mesa einer Kontaktierungsfläche 23 bezeichnet. Dieser Mesa 22 ist hier ein Bestandteil der Schicht 5. Die Kontaktierungsfläche 23 ist eine Metallisierung der Oberseite des Mesa 22. Mit 24 sind metallene Kontaktverbindungen bezeichnet, die elektrischen Kontakt zwischen der streifenförmigen Belegung 7 des Laser-Steges 8 und der Kontaktierungsfläche 23 herstellen. Wie ersichtlich, ist auf den Lateralstegen 20 und dem Mesa 22 das Material der Schicht 6 entfernt, das unter der streifenförmigen Kontaktbelegung zur Gewährleistung eines niederohmigen nicht sperrenden Überganges dient. Zwischen dem Halbleitermaterial der Lateralstege 20 und dem Mesa 22 einerseits und den auf der Oberfläche befindlichen Belegungen 23 und 24 liegt im wesentlichen sperrender Übergang vor. Letzteres entspricht sinngemäß den Verhältnissen einer MCRW-Laserdiode. Mit 25 ist eine Kontaktierungsstelle für einen elektrischen Zuleitungsdraht 26 bezeichnet. Die Gegenelektrode zur streifenförmigen Konaktbelegung 7, d.h. der zweite Anschluß der Laserdiode ist die rückseitige Kontaktierungsbelegung 11 des Substrates 2.

In der Figur ist zu dem einen Lateralsteg 20 gestrichelt eine Kontur 27 angedeutet, die auf die Möglichkeit hinweisen soll, daß ein derartiger Lateralsteg 20 auch als eine Art Brücke ausgebildet sein kann.

Die Lateralstege 20 und/oder der Mesa 22 können anstatt aus Material der Schicht 5 auch aus anderem Material bestehen. In diesem Falle wird auch in den Bereichen der Lateralstege 20 und des Mesa 22 das Material der Schicht 5 bis zur Tiefe d (d') beseitigt und die Lateralstege 20 und der Mesa 22 werden durch aufgebrachtes isolierendes Material gebildet, z.B. aus einem Halbleiteroxyd.

Die Figur zeigt den Steg 8 und die Ausbildung der erfindungsgemäßen Laserdiode auf der in der Figur rechten Seite dieses Steges 8. Auf der linken Seite dieses Steges 8 ist vorteilhafterweise der gleiche Aufbau vorgesehen. Für die Erfindung ist jedoch nur einseitige Anordnung der Lateralstege 20 (und der Kontaktierungsfläche 23 mit dem Mesa 22) nicht ausgeschlossen.

Eine Vielzahl von Lateralstegen 20 begünstigt besonders gleichmäßige Stromverteilung in der Kontaktbelegung 7 und damit im Bereich der laserstrahlungserzeugenden Zone 10 der Schicht 4, d.h. der laseraktiven Schicht. Die Länge einer Kontaktbelegung 7 des Steges 8 beträgt z.B. etwa 200 μm. Die Breite dieser Kontaktbelegung beträgt nur 1 bis etwa 5 μm, vorzugsweise etwa 2 bis 3 μm. Eine solche geringe Breite ist ein besonderer Vorteil der erfindungsgemäßen Laserdiode. Im Regelfall gilt, daß mehrfach größere Breite der Kontaktbelegung 7 entsprechend mehrfach größeren Strom durch die Laserdiode hindurch erfordert, ohne daß entsprechend höhere Intensität verwertbarer Laserstrahlung zur Verfügung steht.

Bei einer Anzahl von z.B. 4 bzw. 8 Lateralstegen 20, verteilt über die Länge von zum Beispiel 200 μm bzw. 400 μm des Steges 8 bzw. der Kontaktbelegung 7, empfiehlt sich für die Breite der Lateralstege ein Maß im Bereich von z.B. 3 bis 20 μm. Für das Maß der Fläche der Kontaktierungsfläche 23 besteht relativ freie Wahl, da ihre Größe praktisch keine Einwirkung auf die Verhältnisse im Bereich der Laserstrahlungserzeugung 10 hat.

Ein bezogen auf den Steg 8 symmetrischer Aufbau einer erfindungsgemäßen Laserdiode kann auch im Hinblick auf thermische Stabilität von Vorteil sein.

Bezugszeichenliste

 1 Laserdiode
 2 Substratkörper
 3 erste Schicht
 4 zweite (laseraktive) Schicht
 5 dritte Schicht
 6 vierte Schicht
 7 streifenförmige Kontaktbelegung
 8 Steg
 9 Flanken des Steges 8
 10 Austrittsstelle der Laserstrahlung
 11 Kontaktierungsbelegung des Substratkörpers 2
 20 Lateralsteg
 22 Kontaktierungsfläche
 23 Kontaktierungsfläche
 24 elektrische Kontaktverbindung
 25 Kontaktierungsstelle für Zuleitung 26
 26 Zuleitung
 27 Brücke
 a, w Breite
 d, d' Tiefe

**Ansprüche**

1. Laserdiode (1) mit Doppelheteroschichtstruktur (3, 4, 5, 6) und streifenförmigem, kleiner als 10 μm breitem Steg (8) mit einer Oberseite und seitlichen Flanken und mit Kontaktbelegung (7), wobei die der laseraktiven Schicht (4) benachbarte, zwischen der laseraktiven Schicht (4) und der Kontaktbelegung (7) befindliche dritte Schicht (5) der Doppelheteroschichtstruktur (3, 4, 5, 6) seitlich des Steges (8) zur Verbesserung der Wellenführung verringerte Dicke besitzt und mit einer Kontaktierungsfläche (22, 23), **gekennzeichnet dadurch,**

-daß die Kontaktbelegung (7) auf im wesentlichen die Oberseite des Steges (8) beschränkt ist,

-daß die dritte Schicht (5) der Doppelheteroschichtstruktur seitlich des Steges (8) nahezu bis vollständig (d,d') entfernt ist,

-daß wenigstens ein sich seitlich des Steges (8) erstreckender Lateralsteg (20) mit einer Oberseite vorgesehen ist, der eine seitliche Verbindung zwischen dem Steg (8) und der Kontaktierungsfläche -

(22, 23) bildet und
-daß auf der Oberseite dieses (jeweiligen) Lateralsteges (20) eine elektrische Kontaktverbindung - (24) zwischen der Kontaktbelegung (7) des Steges (8) und der Kontaktierungsfläche (23) gebildet ist.

2. Laserdiode nach Anspruch 1, **gekennzeichnet dadurch**, daß ein Lateralsteg / mehrere Lateralstege (20) als Brücke (27) zwischen dem Steg - (8) und der Kontaktierungsfläche (23) ausgebildet sind.

3. Laserdiode nach Anspruch 1 oder 2, **gekennzeichnet dadurch**, daß der Lateralsteg / die Lateralstege (20) auf beiden Seiten des Steges (8) verteilt angeordnet sind.

4. Laserdiode nach Anspruch 1, 2 oder 3, **gekennzeichnet dadurch**, daß der Lateralsteg / die Lateralstege (20) auf beiden Seiten des Steges (8) symmetrisch angeordnet sind.

5. Laserdiode nach einem der Ansprüche 1 bis 4, **gekennzeichnet dadurch**, daß seitlich des Steges (8) und außerhalb des Lateralsteges / der Lateralstege (20) die dritte Schicht (5) bis auf eine Restdicke unterhalb 0,4 $\mu$m beseitigt ist (Fig.).

6. Laserdiode nach einem der Ansprüche 1 bis 4, **gekennzeichnet dadurch**, daß seitlich des Steges (8) und außerhalb des Lateralsteges / der Lateralstege (20) das Material der dritten Schicht (5) bis herab auf die Oberfläche der zweiten, laseraktiven Schicht (4) beseitigt ist (Restdicke = 0).

7. Laserdiode nach einem der Ansprüche 1 bis 4, **gekennzeichnet dadurch** , daß seitlich des Steges (8) und außerhalb des Lateralsteges / der Lateralstege (20) das Material der dritten Schicht - (5) und der zweiten Schicht (4) bis unterhalb (d') der zweiten Schicht (4) beseitigt ist (Fig.).

8. Laserdiode nach einem der Ansprüche 2 bis 7, **gekennzeichnet dadurch**, daß beidseitig des Steges (8) eine Kontaktierungsfläche (22, 23) vorgesehen ist.

9. Laserdiode nach einem der Ansprüche 1 bis 8, **gekennzeichnet dadurch**, daß sich eine Kontaktierungsfläche (23) auf einem Mesa (22) befindet.

10. Laserdiode nach einem der Ansprüche 1 bis 9, **gekennzeichnet dadurch** , daß das Material des Lateralsteges / der Lateralstege (20) Halbleitermaterial der dritten Schicht (5) ist.

11. Laserdiode nach einem der Ansprüche 1 bis 9, **gekennzeichnet dadurch**, daß das Material des Lateralsteges / der Lateralstege (20) nach Beseitigung des Materials der dritten Schicht (5) neu aufgebrachtes, elektrisch isolierendes Material ist.

12. Laserdiode nach einem der Ansprüche 1 bis 10, **gekennzeichnet dadurch**, daß das Material des unterhalb der Kontaktierungsfläche (23) befindlichen Mesa (22) Halbleitermaterial der dritten Schicht (5) ist.

13. Laserdiode nach einem der Ansprüche 1 bis 11, **gekennzeichnet dadurch**, daß das unterhalb der Kontaktierungsfläche (23) befindliche Material des Mesa (22) neu aufgebrachtes elektrisch isolierendes Material ist.

0 236 713